# EUROPEAN PATENT APPLICATION

(11) **EP 0 961 398 A1**
(43) Date of publication of application: **01.12.1999**
(21) Application number: 99303583.1
(22) Date of filing: 07.05.1999
(51) Int. Cl.: H03D 7/14

(54) **Mixer circuit arrangements**

(30) Priority: 27.05.1998 GB 9811345
(71) Applicant: Mitel Semiconductor Limited, Swindon, Wiltshire SN2 2QW (GB)
(72) Inventor: Sawyer, David Albert, Swindon, Wilts (GB); Madni, Arshad, Swindon, Wilts SN2 3QP (GB); Leroux, Helen, Swindon, Wilts SN1 4EZ (GB); Trodd, Lance, Swindon, Wilts (GB)
(74) Representative: Robinson, John Stuart

(57) **Abstract**

A mixer circuit arrangement for frequency - changing an RF input signal to an IF signal comprises an input stage (40), a filter stage (41), and a mixer stage (42). The input stage (40) supplies differential current signals to the filter stage (41), which attenuates image signals and preferably also local oscillator signals. The mixer stage (42) mixes the filtered differential current signals with the local oscillator signal to provide the IF signal.

## Description

The present invention relates to mixer circuit arrangements, and more particularly although not exclusively, to a mixer circuit arrangement for use as a first upconversion mixer in a cable television receiver.

Mixer circuits are commonly used to perform a frequency translation of a modulated input signal such that the output signal contains all the same phase and amplitude modulation present on the input signal translated onto a different output carrier frequency. The output carrier frequency can be either higher or lower than the frequency of the input carrier. These frequency translations are known respectively as upconversion and downconversion. Frequency translation of an input signal in this way necessarily results in degradation of the quality of the signal. Degradation is caused particularly by the addition of thermal noise, signal distortion through the use of nonlinear components, the addition of signals harmonically related to both the frequency of the local oscillator used in the frequency translation and the input carrier frequency, leakage of the input signal to the output, and leakage of the local oscillator signal into both the input and the output.

Where a mixer circuit is used in heterodyne reception, the effect of image response can present difficulties, of which image interference can be the most significant problem. Here, input signals of or near to a frequency which differs from the local oscillator frequency by an amount equal to the difference between the local oscillator frequency and the wanted input carrier frequency appear scrambled with the desired signal, i.e. the resultant spectra overlap, at the mixer output. It is known to use frequency tracking filters at the inputs of mixer circuits to attenuate input signals which may cause image interference. It is known also to use certain types of mixers known as image reject mixers. Each of these has the disadvantage of requiring considerable chip area or being expensive in terms of the numbers of discrete components required.

EP 0 171 653 discloses a mixer circuit arrangement comprising a long-tail pair with a constant current tail source acting as a voltage to current converter and cross-coupled differential pairs acting as a mixer cell. The differential outputs of the converter are connected to the inputs of the mixer cell via DC-blocking coupling capacitors which prevent the quiescent current of the long-tail pair from passing through the mixer cell. The quiescent currents of the differential pairs are set by individual current sources.

US 5 494 194 discloses a mixer circuit arrangement comprising a long tail pair operating with a single-ended input and acting as a voltage to current converter. The outputs of the converter are connected to a pair of transistors acting as a mixer cell. The outputs of the converter are also connected together via an impedance which may be a resistor, a capacitor, an inductor, a series resonant circuit or a parallel resonant circuit. The impedance is used to cause the mixer cell transistors to operate as a differential pair and so is arranged to have a low value at the frequency of the signals supplied to those mixer cell inputs which are not connected to the converter.

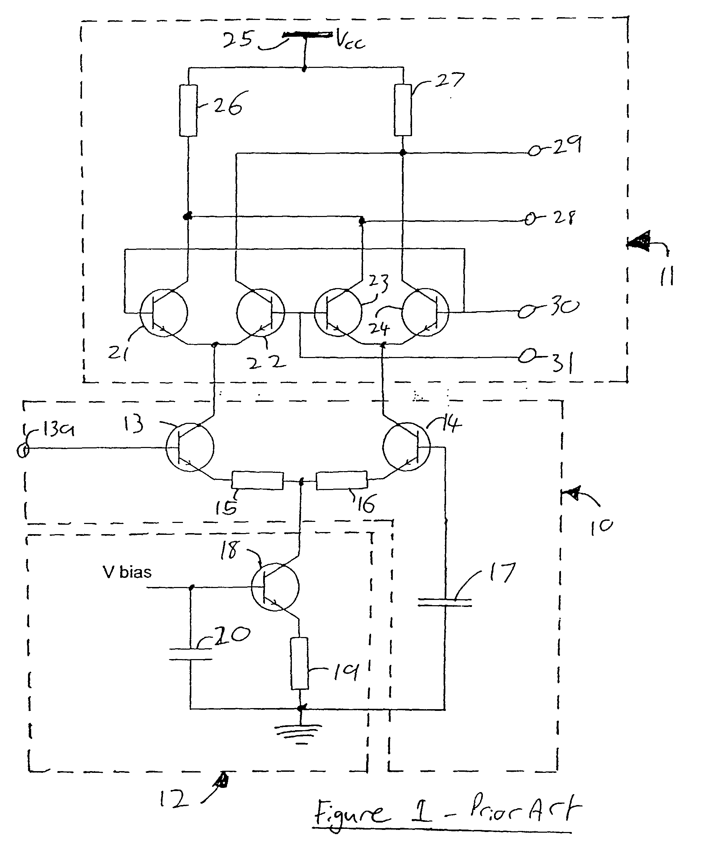

Figure 1 shows a known mixer circuit arrangement, known as a Gilbert cell mixer. The arrangement comprises generally an input stage 10, a mixer core 11, and a current source 12.

The input stage comprises first and second npn transistors 13 and 14, each of which has its emitter electrodes connected to an output of the current source 12 by respective ones of emitter degeneration or series feedback resistors 15 and 16. The base electrode of the second transistor 14 is connected to ground potential by a capacitor 17. The base electrode of the first transistor 13 serves as the input 13a to the mixer circuit arrangement. The current source 12 includes a transistor 18, an emitter grounding resistor 19 and a capacitor 20, which is connected between the base electrode of the transistor 18 and ground potential. The base electrode of the transistor 18 is biased by a voltage source (not shown). The collector electrode of the transistor 18 forms the output of the current source 12. The current source 12 is a high impedance current source, which sets the quiescent current for the whole of the mixer circuit arrangement.

The mixer core 11 includes first to fourth npn transistors 21 to 24, the collector electrodes of which are cross-connected and connected to a Vcc to supply line 25 by respective ones of load resistors 26 and 27. First and second output terminals 28 and 29 are connected to the lower terminals of the load resistors 26 and 27. Local oscillator input terminals 30 and 31 are connected to the base electrodes of the mixer core transistors 21 to 24.

Such a Gilbert cell mixer can provide gain, the value of which is dependent on the values of components selected, and is satisfactory at preventing input signals from the input terminal 13a leaking through to the output terminals 28 and 29. A Gilbert cell mixer, because it is balanced, is also satisfactory at preventing local oscillator signals applied to the terminals 30 and 31 leaking through to the output terminals 28 and 29. However, when the Gilbert cell mixer is used in a single-ended input configuration, as shown in Figure 1, the performance of the circuit arrangement is impaired compared to when a fully balanced arrangement is used. Impaired parameters include noise figure, second order input intercept point, local oscillator leakage to output figure and local oscillator leakage to input figure.

The input stage 10 serves as a transconductance amplifier, supplying differential current signals on the collector electrodes of the transistors 13 and 14. A local oscillator signal applied to the terminals 30 and 31 switches the mixer core transistors 21 to 24 such that the current signal from each of the transistors 13 and 14 is switched between respective ones of the load resistors 26 and 27. This results in the energy of the input signal being transferred principally into two equal power primary sideband signals at carrier frequencies equal to sum and the difference between the local oscillator frequency and the input signal frequency. Further sidebands are also generated around the harmonics of the local oscillator signal frequency. These other sidebands account for about 10% of the original signal energy. Hence, with almost half of the energy of the signal being transferred into one or other of the primary sidebands, the resultant energy in the required primary sideband, i.e. the wanted signal, is some 4 to 5dB down on that entering the mixer core 11 from the output of the input stage 10.

In the absence of any filtering of the input signal or any image signal rejection, the Gilbert cell of Figure 1 is unlikely to be able to provide usable output signals where the input signal is a broadband signal containing many adjacent channels from which a single channel is desired.

The use of a frequency tracking filter on the input to the input stage 10, as well as contributing to a relatively expensive mixer circuit arrangement, is imperfect in that any noise energy generated after this filter in the signal path, such as noise generated in the input stage 10, is not subjected to any filtering and consequently carries through to contribute to the total output noise. This noise includes thermal noise, distortion and interference from both the image and the wanted signal bands as well as local oscillator leakage and the like.

Image reject mixers which mix an input signal with each of in-phase and quadrature local oscillator signals and combine the results to achieve signal cancellation, whilst generally good at attenuating signals at image frequencies, provide no filtering of local oscillator and associated harmonic signals, nor of image noise.

According to the invention, there is provided a mixer circuit arrangement for frequency-translating an input signal by an amount dependent on the frequency of a local oscillator signal to provide an output signal, comprising an input stage, a filter stage and a mixer stage, the input stage being arranged to convert the input signal into differential current signals and the mixer stage being arranged to mix the filtered differential current signals with the local oscillator signal to provide the output signal, characterised in that the filter stage is arranged to filter the differential current signals to provide attenuation in the image channel.

The filter stage may be arranged to provide attenuation at the frequency of the local oscillator signal.

The input stage may comprise an emitter coupled pair of transistors. The base electrode of one of the emitter coupled transistors may be connected to ground potential by a capacitor and the base electrode of the other transistor may be connected to receive the input signal.

The input stage, the filter and the mixer stage may be connected in cascode.

The mixer stage may have first and second inputs connected to the filter stage and via first and second resistors, respectively, to ground potential.

The mixer stage may comprise a plurality of transistors and a series feedback component may be connected in the emitter or source path of each of the transistors of the mixer stage. Each of the series feedback components may comprise a resistor or an inductor.

The filter stage may comprise an elliptical filter. The elliptical filter may comprise a fifth order elliptical filter.

The input stage may have a high impedance output, the mixer stage may have a low impedance input and the filter stage may provide impedance matching therebetween.

It is thus possible to provide an arrangement in which image channel signals, which may comprise interfering signals or may merely comprise noise, can be attenuated so as to reduce interference and/or so as to improve the noise performance. By providing attenuation at the local oscillator frequency, leakage of the local oscillator signal to the input of the mixer arrangement may be reduced. The first and second resistors, when present, allow increased quiescent current to flow through transistors of the mixer stage. The use of series feedback components, when present, reduces noise produced in the mixer stage by transistors when switching. Impedance matching, when present, improves the transfer of signals from the input stage via the filter to the mixer stage and so improves the gain of the arrangement.

An embodiment of the present invention will now be described with reference to the accompanying drawings, of which:
Figure 1 shows a prior art mixer circuit arrangement;
Figure 2 shows a mixer circuit arrangement constituting an embodiment of the present invention; and
Figure 3 shows an example of a filter circuit of the mixer circuit arrangement of Figure 2.

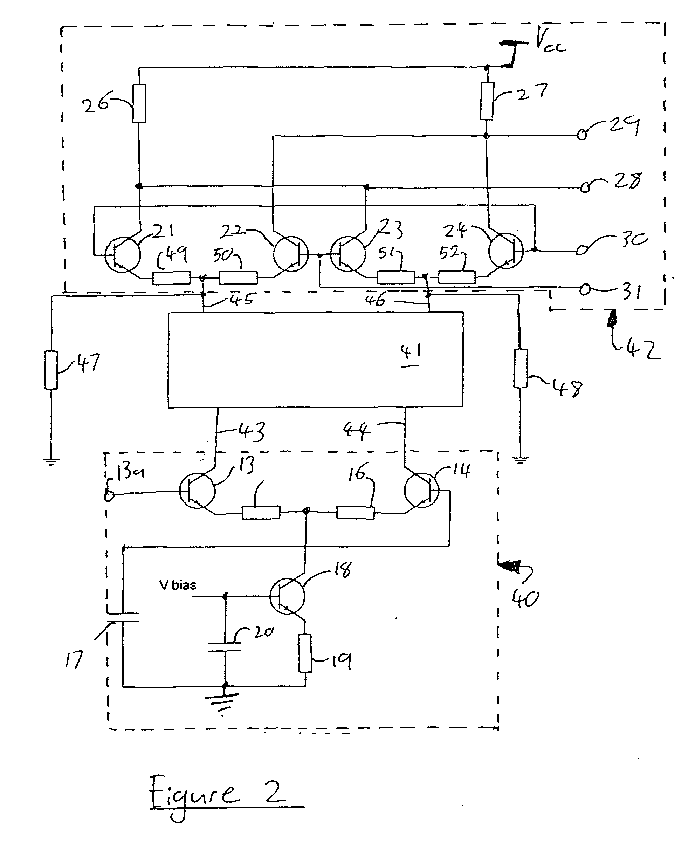

In Figure 2, the mixer circuit arrangement comprises an input stage 40, a filter stage 41 and a mixer core 42 connected in cascode. The input stage 40 is the same as the input stage 10 and the current source 12 of Figure I, from which reference numerals have been retained for like elements.

The filter stage 41 is a twin port network having first and second inputs connected to collector electrodes 43 and 44 of the transistors 13 and 14, respectively. First and second filter stage outputs are connected to inputs 45 and 46, respectively, of the mixer core 42, which are also grounded by resistors 47 and 48, respectively. The mixer core 42 is the same as the mixer core 11 of Figure 1, from which reference numerals have been retained for like elements, except for the inclusion here of first to fourth resistors 49 to 52, which are connected in the emitter paths of the mixer core transistors 21 to 24, respectively.

A single-ended voltage signal received on the input terminal 13a is converted by the input stage 40 into a differential current signal which is provided on the collector electrodes 43 and 44 and is thus applied to the inputs of the filter stage 41.

The filter stage 41 filters the differential current signal provided by the input stage 40 and provides a filtered differential current signal to the mixer core inputs 45 and 46. The filter stage 41 serves also to filter the signals which pass from the mixer core 42 to the input stage 40. Such signals include components provided by leakage from the local oscillator input terminals 30 and 31 and harmonics of those local oscillator signals. The filter stage 41 thus increases the second order input intercept performance of the mixer circuit arrangement, which is particularly noticeable when the input stage 40 is an unbalanced, single-ended input stage as it is in this embodiment.

The filter stage 41 further provides an impedance transformation between the high impedance presented by the collectors of the input stage transistors 13, 14 and the low impedance presented by the emitters of the mixer core transistors 21 to 24. This allows the components of the mixer circuit arrangement to be selected such as to provide reasonably high levels of gain without significantly increasing the noise figure of the arrangement. This increased gain can be obtained without a significant increase in the quiescent current provided by the current source 18, 19, 20.

In filtering the differential current signal provided by the input stage 40, the filter stage 41 suppresses the image frequency signals whilst allowing passage of the desired frequency signals to the mixer core inputs 45 and 46. This eliminates the need for a frequency tracking filter to be provided on the input of the input stage 40.

The resistors 47 and 48 have the effect of providing an increased quiescent current in the mixer core 42. This is preferred because the impedance transformation provided by the filter stage 41 increases the signal current provided into the mixer core 42. The impedance transformation provided by the filter stage 41 increases the gain of the mixer and reduces the contribution to noise provided by the mixer core 42.

The resistors 49 to 52 provide series feedback in the emitter paths of the mixer core transistors 21 to 24, respectively, thereby reducing the noise produced by these transistors 21 to 24 when switching. Inductors could be used in place of the resistors 49 to 52. Such elements may even be preferable to resistors in that they could be used to attenuate spurious signal energy generated by the switching of the mixer core 42 at harmonics of the local oscillator frequency and of the frequency of the output signal. Of course, inductors would also introduce less thermal noise than do the resistors 49 to 52.

Whatever components are selected for the series feedback components 49 to 52, the rbb and collector shot noise of the mixer core transistors 21 to 24 is less than would be found in their absence. The input impedance of the mixer core transistors 21 to 24 is also increased, which lessens the amount of output impedance modulation caused by the local oscillator. Output impedance modulation is the name given to the effect of the impedance provided at the output terminal varying as a function of the signal level provided on the local oscillator input terminals 30,31.

This reduced output impedance modulation, in turn, causes an increased impedance to be presented by the collector electrodes of the mixer core transistors 21 to 24 and thus a higher impedance to be presented at the output terminals 28,29. This contributes to an improved output intermodulation intercept figure, which is of particular utility and significance when the mixer circuit arrangement is required to provide relatively large output signals. Such signals may be required in, for example, cable television receivers and broadband cellular applications, such as CDMA and wideband CDMA.

Such a mixer circuit arrangement is suitable for use as the first upconversion mixer in a cable television double conversion receiver. Such mixers are required to select one of the one hundred and thirty-two channels, which are spaced evenly in frequency between 50 MHz and 850 MHz, and upconvert the signal of that channel to 1.1 GHz. To achieve this, the local oscillator signal must be variable between 1.15 GHz and 1.95 GHz, thereby producing image signals between 2.25 GHz and 3.05 GHz, depending on the channel selected.

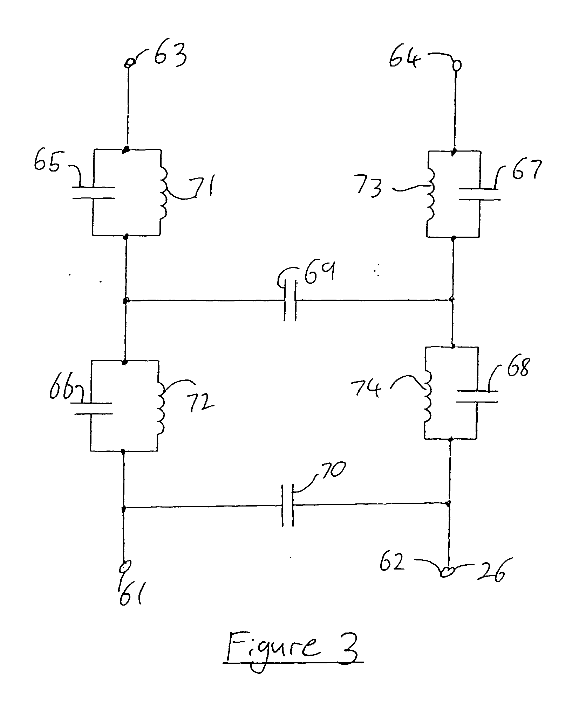

The filter stage 41 of Figure 2 is shown in Figure 3 and comprises first and second input terminals 61 and 62, first and second output terminals 63 and 64, first to sixth capacitors 65 to 70 and first to fourth inductors 71 to 74. The filter thus provided is of a type known as a fifth order elliptical filter. If each of the capacitors 65 to 68 is a 3pF capacitor, each of the capacitors 69 and 70 is a 2.2 pF capacitor and each of the inductors 71 to 74 is a 5 nH inductor, the filter circuit 60 has a stop band of 1.15 to 4 GHz and a pass band of 50 to 850 MHz. This filter therefore attenuates both the image signals and the local oscillator signals of the cable television receiver, whilst allowing the wanted signals to pass therethrough. Even if there are no signals present in the image channel, the image channel noise which would otherwise appear at the mixer output is attenuated by the filter stage 41 and thus improves the noise figure of the mixer by substantially 3dB.

Although a Gilbert cell mixer arrangement has been described hereinbefore, other arrangements, for example using any other type of transconductor, could be used. Such transconductors include micro mixer circuits, single balanced mixers and the like, including transconductors having differential inputs, as long as a differential current signal is provided as an output signal.

## Claims

1. A mixer circuit arrangement for frequency-translating an input signal by an amount dependent on the frequency of a local oscillator signal to provide an output signal, comprising an input stage (40), a filter stage (41) and a mixer stage (42), the input stage (40) being arranged to convert the input signal into differential current signals and the mixer stage (42) being arranged to mix the filtered differential current signals with the local oscillator signal to provide the output signal, characterised in that the filter stage (41) is arranged to filter the differential current signals to provide attenuation in the image channel.

2. An arrangement as claimed in claim I, characterised in that the filter stage (41) is arranged to provide attenuation at the frequency of the local oscillator signal.

3. An arrangement as claimed in claim 1 or 2, characterised in that the input stage (40) comprises an emitter coupled pair oftransistors (13,14).

4. An arrangement as claimed in claim 3, characterised in that the base electrode of one (14) of the emitter coupled transistors (13,14) is connected to ground potential by a capacitor (17) and the base electrode of the other transistor (13) is connected to receive the input signal.

5. An arrangement as claimed in any preceding claim, characterised in that the input stage (40), the filter stage (41) and the mixer stage (42) are connected in cascode.

6. An arrangement as claimed in any preceding claim, characterised in that the mixer stage (42) has first and second inputs (45,46) connected to the filter stage (41) and via first and second resistors (47,48), respectively, to ground potential.

7. An arrangement as claimed in any preceding claim, characterised in that the mixer stage (42) comprises a plurality of transistors (21-24) and in that a series feedback component (49-52) is connected in the emitter or source path of each of the transistors (21-24) of the mixer stage (42).

8. An arrangement as claimed in claim 7, characterised in that each of the series feedback components (49-52) comprises a resistor.

9. An arrangement as claimed in claim 7, characterised in that each of the series feedback components (49-52) comprises an inductor.

10. An arrangement as claimed in any preceding claim, characterised in that the filter stage (42) comprises an elliptical filter (61-74).

11. An arrangement as claimed in claim 10, characterised in that the elliptical filter (61-74) comprises a fifth order elliptical filter.

12. An arrangement as claimed in any one of the preceding claims, characterised in that the input stage (40) has a high impedance output, the mixer stage (42) has a low impedance input and the filter stage provides impedance matching therebetween.
